# FASCICULE DE BREVET EUROPEEN

(11) **EP 2 495 764 B1**
(45) Date de publication et mention de la délivrance du brevet: **04.10.2017**
(21) Numéro de dépôt: 12354012.2
(22) Date de dépôt: 02.03.2012
(51) Int. Cl.: H01L 27/146

(54) **Matrice de détection à conditions de polarisation améliorées et procédé de fabrication**
Matrize zur Erfassung von verbesserten Polarisationsbedingungen, und Herstellungsverfahren
Detection matrix with improved polarisation conditions and manufacturing method

(30) Priorité: 04.03.2011 FR 1100663; 04.03.2011 FR 1100661
(43) Date de publication de la demande: 05.09.2012
(73) Titulaire: Société Française de Détecteurs Infrarouges - SOFRADIR, 91120 Palaiseau (FR)
(72) Inventeur: Maillart, Patrick, 38140 La Murette (FR); Chabuel, Fabien, 38130 Echirolles (FR)
(74) Mandataire: Talbot, Alexandre

(56) Documents cités:
- EP-A1- 1 677 353
- EP-A2- 1 530 239
- WO-A1-2006/005803
- US-A1- 2001 012 133

## Description

### Domaine technique de l'invention

L'invention est relative à un dispositif de détection de rayonnement électromagnétique comportant une matrice de photodétecteurs disposés sur un substrat et à son procédé de réalisation.

### État de la technique

Dans le domaine des dispositifs de détection, il y a communément un photodétecteur associé à un circuit de lecture. Le photodétecteur délivre un signal représentatif de la scène observée et ce signal est analysé par le circuit de lecture.

La polarisation du photodétecteur est obtenue au moyen du potentiel de substrat imposé sur une première borne du photodétecteur et au moyen d'un potentiel de référence imposé sur la seconde borne du photodétecteur, par un dispositif de lecture de type amplificateur transimpédance capacitif.

Afin d'obtenir toujours plus d'information sur la scène observée, le photodétecteur a fait place à une pluralité de photodétecteurs. Il y a, de plus, un accroissement constant du nombre de photodétecteurs intégrés dans un circuit de détection afin d'augmenter la définition du détecteur. Cependant, l'intégration d'un grand nombre de photodétecteurs entraîne des difficultés de réalisation et de fonctionnement.

De manière à conserver une surface de collection raisonnable et un faible encombrement du dispositif, la pluralité de photodétecteurs est intégrée sous la forme d'une matrice. Un anneau de polarisation électriquement conducteur entoure la matrice pour imposer le potentiel de substrat à la matrice. Il y a alors un grand nombre de photodétecteurs organisés en matrice et tous les photodétecteurs sont reliés, de manière plus ou moins directe, au potentiel de substrat.

Cette organisation apporte un gain indéniable en ce qui concerne la densité d'intégration, mais elle engendre une difficulté dans la polarisation des différents photodétecteurs.

Les photodiodes sont généraiement polarisées en inverse afin de délivrer un courant représentatif de la scène observée. La photodiode joue alors le rôle d'un générateur de courant. La polarisation de la photodiode est appliquée d'un côté par le substrat et de l'autre par le circuit de lecture. Dans ce régime de fonctionnement, la modélisation électrique d'une photodiode de la matrice peut être représentée par une résistance dynamique montée en parallèle du générateur de courant et une résistance série montée en série de l'ensemble.

On constate alors que la résistance série de la photodiode peut entraîner une modification de la polarisation à ses bornes. En effet, selon l'intensité du courant généré par la source de courant, le potentiel aux bornes de la photodiode peut évoluer. De plus, l'organisation en matrice des différentes photodiodes fait que ces évolutions de potentiels peuvent se cumuler et se traduire par la dépolarisation d'une ou plusieurs photodiodes situées dans la partie centrale de la matrice.

Comme la composante essentielle de la dépolarisation est résistive, ce risque de dépolarisation est d'autant plus marqué que le courant généré par le photodétecteur est important. On remarque également que ce phénomène est d'autant plus important que la matrice de photodétecteurs est importante et que la valeur de résistance est élevée.

Il existe alors un risque d'avoir au moins un photodétecteur qui ne travaille plus dans sa plage de fonctionnement optimum. Il en résulte alors des problèmes de linéarité entre le courant fourni par le photodétecteur et le flux incident. Ce genre de problème est difficile ou impossible à corriger par des dispositifs de correction d'image appliqués à l'ensemble de la matrice.

Il existe donc un frein à l'intégration des matrices de grandes dimensions et/ou des matrices travaillant avec des courants élevés.

Une solution a été apportée par le document WO9815016A1 qui modifie le substrat en intégrant une zone fortement dopée sous les photodétecteurs. Cette zone fortement dopée permet de favoriser le transport des porteurs de charge en réduisant la résistivité du substrat. Cependant, cette modification du substrat comporte un coût et elle ne peut pas être réalisée avec toutes les techniques habituelles de croissance. Cette solution n'est donc pas facilement intégrable.

Le document US2001/0012133 décrit une matrice de photodiodes avec différentes configurations de polarisations des photodiodes. Dans un mode de réalisation, un contact est réalisé par photodiode avec ou non réalisation d'un anneau périphérique de polarisation. Dans un autre mode de réalisation des contacts arrangés en colonne séparent des matrices de photodiodes.

Le document EP1667353 décrit une matrice de photodiodes réalisée dans un substrat de type N. Chaque photodiode est entourée d'un caisson de type N puis d'un caisson de type P.

### Objet de l'Invention

On constate qu'il existe un besoin de prévoir un dispositif de détection qui présente un fonctionnement plus robuste.

On tend à combler ce besoin au moyen d'un dispositif selon la revendication 1.

On constate qu'il existe un besoin de prévoir un procédé de fabrication d'un tel dispositif de manière simple.

On tend à combler ce besoin au moyen d'un procédé selon la revendication 6.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :
- les figures 1 et 2 représentent, de manière schématique, des matrices de photodétecteurs d'un dispositif de détection,
- la figure 3 représente, de manière schématique, en coupe, plusieurs photodétecteurs et un contact selon l'un des axes d'organisation,
- la figure 4 représente, de manière schématique, en coupe, une variante de réalisation de plusieurs photodétecteurs et d'un contact selon l'un des axes d'organisation.

### Description de modes de réalisation préférentiels de l'invention

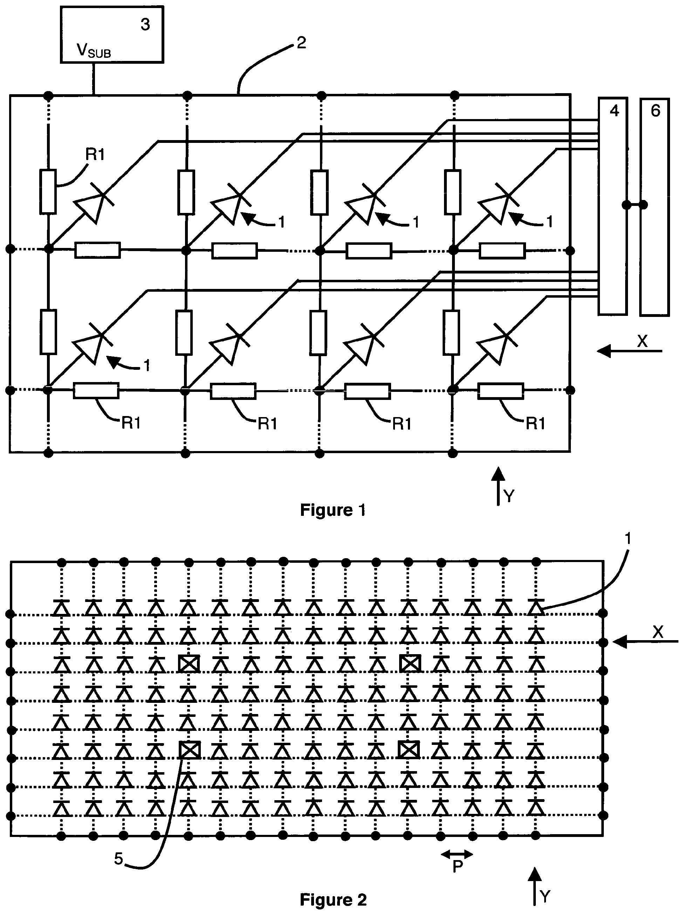

Comme cela est illustré aux figures 1 et 2, le dispositif de détection comporte une pluralité de photodétecteurs 1 qui sont organisés en matrice. Les photodétecteurs 1 sont organisés selon un premier axe d'organisation X, c'est-à-dire que les photodétecteurs 1 forment une rangée ou une colonne selon ce premier axe X. Les photodétecteurs sont organisés selon l'axe X avec un pas de répétition P.

Dans un exemple illustré, la pluralité de photodétecteurs 1 est également organisée selon un deuxième axe d'organisation Y qui est sécant au premier axe d'organisation X. A titre d'exemple, le premier axe d'organisation X est perpendiculaire au deuxième axe d'organisation Y. De cette manière, les photodétecteurs 1 sont organisés les uns par rapport aux autres selon deux directions différentes représentées par le premier et le deuxième axe d'organisation.

De cette manière, les photodétecteurs 1 sont alignés entre eux selon une ou plusieurs lignes parallèles à l'axe X et ils sont éventuellement alignés selon une ou plusieurs lignes parallèles à l'axe Y. Les photodétecteurs 1 sont alors organisés en rangées et en colonnes.

La matrice de photodétecteurs 1 est formée sur un substrat en matériau semi-conducteur et elle est entourée par une ligne 2 périphérique de polarisation. La ligne 2 est une ligne en matériau électriquement conducteur, par exemple une ligne métallique qui court à la surface du substrat. Dans d'autres exemples, la ligne 2 est une zone dopée du substrat, cette zone est plus fortement dopée que le reste du substrat afin de diminuer la chute de potentiel le long de la ligne. De manière préférentielle, la ligne 2 est une zone dopée qui est du même type de conductivité que le substrat. Le substrat est d'un premier type de conductivité, par exemple de type P.

La ligne 2 périphérique de polarisation est reliée à un générateur 3 de tension de polarisation. La tension de polarisation V_{SUB} ou une tension proche de cette dernière est appliquée aux photodétecteurs 1 via la ligne 2 de polarisation et le substrat. La tension de polarisation V_{SUB} fixe en partie les conditions de polarisation des photodétecteurs 1 en appliquant un premier potentiel sur une première électrode du photodétecteur 1. La tension de polarisation V_{SUB} ou une tension qui en découle est appliquée sur la première électrode des différents photodétecteurs 1. Une seconde tension, une tension de référence, est appliquée sur une seconde électrode des photodétecteurs afin de fixer les conditions de polarisation des différents photodétecteurs 1. De manière avantageuse, les photodétecteurs sont polarisés en inverse entre la tension de polarisation V_{SUB} et la tension de référence.

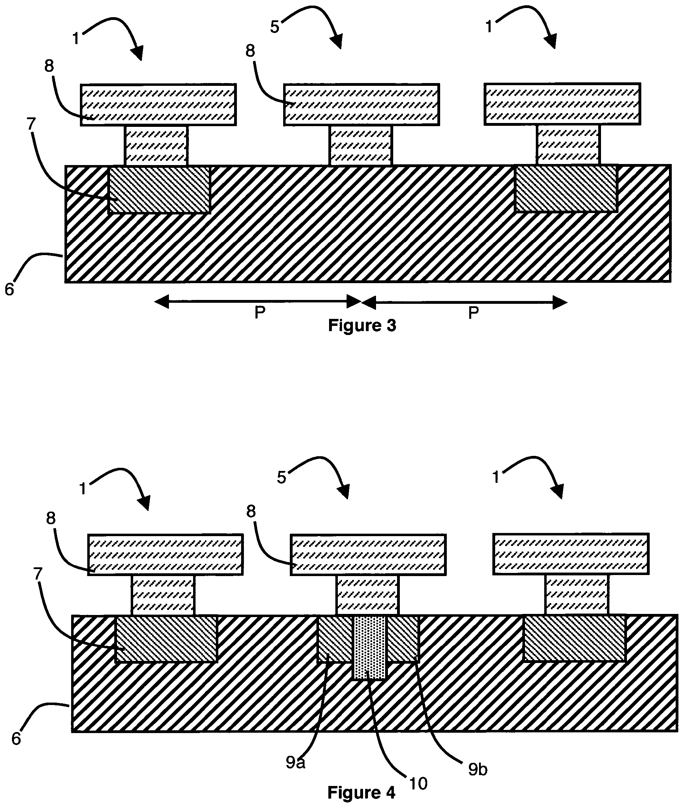

Dans un exemple illustré à la figure 3, chaque photodétecteur 1 est formé au moins partiellement par une partie du substrat 1 semi-conducteur. Par exemple, la première électrode est formée par le substrat 1 ce qui permet de faciliter l'intégration de la matrice dans le substrat et limiter les écarts de polarisation. Dans un exemple encore plus privilégié, les photodétecteurs sont formés dans le substrat. Le photodétecteur est une photodiode de type PN ou NP dont la première électrode est formée par le substrat 6, une première zone du premier type de conductivité et la seconde électrode est une seconde 7 zone du second type de conductivité formée dans le substrat.

A titre d'exemple, chaque photodétecteur 1 est associé à un circuit de lecture qui impose la tension de référence sur la seconde électrode des photodétecteurs 1. Sur la figure 1, les différents circuits de lecture sont regroupés afin de former des moyens de lecture ou un dispositif de lecture 4 qui comporte une matrice de circuits de lecture. Chaque circuit de lecture est associé à un ou plusieurs photodétecteurs 1 et récupère le signal électrique émis. Dans une variante de réalisation, la fonction de lecture de l'information électrique émise par les photodétecteurs 1 et la fonction de polarisation sont dissociées et il est possible d'associer un photodétecteur 1 à un circuit de lecture et à un dispositif de polarisation.

En fonctionnement, le substrat n'est pas toujours en mesure d'assurer le transport des porteurs de charges émis par les différents photodétecteurs 1 jusqu'à la ligne de polarisation 2 ce qui se traduit par une évolution des conditions de polarisation de certains photodétecteurs 1 depuis le substrat.

Comme illustré à la figure 2, le dispositif comporte également un ou plusieurs contacts 5 ponctuels électriquement conducteurs qui sont connectés, d'une part, au substrat et, d'autre part, au générateur 3 de tension de polarisation. Les contacts 5 électriquement conducteurs sont formés dans la matrice de photodétecteurs 1 à la place d'un photodétecteur 1. Le contact 5 comporte des moyens d'application de la tension de polarisation V_{SUB} sur le substrat.

Le contact 5 relie le générateur 3 de tension de polarisation avec une zone en premier type de conductivité du substrat. Le contact 5 comporte un plot 8 électriquement conducteur qui a une interface avec une zone en premier type de conductivité du substrat de manière à appliquer directement la tension de polarisation V_{SUB} dans la matrice de photodétecteurs 1. Les contacts 5 agissent comme des contacts directs entre le substrat, une zone du premier type de conductivité, et le générateur 3 de tension de polarisation.

De cette manière, les contacts 5 sont le relais de la ligne 2 de polarisation à l'intérieur de la matrice de photodétecteurs 1. Les contacts 5 permettent de réduire la distance que doit parcourir une charge émise par les photodétecteurs 1 pour atteindre la tension de polarisation V_{SUB} et être éjectée du substrat.

Comme cela est illustré à la figure 3 en coupe, le contact 5 est sensiblement identique à un photodétecteur 1. Le contact 5 et le photodétecteur 1 comportent chacun un plot 8 électriquement conducteur. Dans le cas où le photodétecteur 1 est une diode PN ou NP, ce plot 8 est déposé sur le substrat comme pour le contact 5.

Dans le cas du photodétecteur, une extrémité du plot 8 est reliée au circuit de lecture. L'autre extrémité du plot 8 est déposée sur une zone du second type de conductivité du substrat ce qui permet de polariser le photodétecteur 1, ici la diode.

Dans le cas du contact 5, une extrémité du plot 8 est reliée au générateur 3 de tension de polarisation. L'autre extrémité du plot 8 est déposée sur la zone 6 du premier type de conductivité du substrat ce qui permet d'appliquer directement la tension de polarisation V_{SUB} sur le substrat et non sur une diode.

Comme les architectures du contact 5 et du photodétecteur 1 sont similaires, des étapes communes de réalisation peuvent être utilisées afin de faciliter la mise en oeuvre et conserver une densité d'intégration importante.

Dans un exemple particulier, il est possible de réaliser le contact 5 en protégeant cette partie du substrat lors de la formation de la zone en second type de conductivité. De cette manière, le substrat comporte plusieurs zones 7 du second type de conductivité qui vont servir à la formation des photodétecteurs 1 et une zone dépourvue de ce dopage qui va servir à la formation du contact 5.

Cette étape technologique permet de former une matrice de zones 7 du second type de conductivité organisés selon un premier axe d'alignement X et une zone du premier type de conductivité. La zone du premier type de conductivité est aligné avec les zones 7 du second type de conductivité. La distance qui sépare la zone du premier type de conductivité des deux zones du second type de conductivité plus proches voisines est égale au pas de répétition qui existe entre deux zones du second type de conductivité consécutives. Le pas de répétition est celui des photodétecteurs dans la matrice.

Ensuite, une étape commune de formation des plots 8 est réalisée sans tenir compte du fait que le plot 8 peut être formé pour un contact ou pour un photodétecteur 1. A titre d'exemple, les plots 8 ont des dimensions latérales (longueur et largeur) identiques et ils peuvent être formés par le même matériau. Le plot 8 en matériau électriquement conducteur est formé sur les zones du second type de conductivité et la zone du premier type de conductivité.

Comme le contact 5 électriquement conducteur est formé à la place d'un photodétecteur 1, le contact 5 est aligné suivant le premier axe d'organisation X avec les autres photodétecteurs 1 de la même colonne ou de la même rangée. Un contact 5 a deux photodétecteurs 1 comme plus proches voisins, sur le premier axe d'organisation X. La distance qui sépare le contact 5 de ces deux photodétecteurs 1 plus proches voisins est égale à la distance qui sépare deux photodétecteurs 1 adjacents selon le premier axe d'organisation X. Il y a un pas de répétition P qui est constant le long du premier axe d'organisation, ce pas de répétition P sépare deux éléments consécutifs, soit deux photodétecteurs 1, soit un photodétecteur 1 et un contact 5 électriquement conducteur.

Dans un mode exemple, deux contacts 5 sont adjacents et consécutifs dans une des directions d'organisation. Cet exemple est moins intéressant que deux contacts 5 séparés par quelques photodétecteurs.

Le contact 5 est parfaitement intégré dans la matrice de photodétecteurs, son encombrement est identique à celui d'un photodétecteur.

De manière préférentielle, si plusieurs contacts 5 sont formés dans la matrice de photodétecteurs 1, les contacts 5 sont répartis à intervalle régulier selon le premier axe d'organisation X. La distance séparant deux contacts 5 est un multiple entier du pas de répétition P de la matrice selon le premier axe X ce qui peut définir un premier pas de répétition spécifique aux contacts 5. La distance de répétition est choisie de manière à éviter que les conditions de polarisation des photodétecteurs 1 soient modifiées au-delà d'une valeur seuil.

La distance de répétition des contacts 5 peut donc être définie dès la phase de dimensionnement du dispositif en fonction des conditions de polarisation appliquées, des conditions d'illumination maximales applicables et des propriétés électriques du substrat.

Comme le contact 5 électriquement conducteur est formé à la place d'un photodétecteur 1, il n'y a pas intégration d'un élément supplémentaire dans la matrice. Cette solution peut donc être intégrée dans les matrices où le pas de répétition est petit, par exemple pour un pas de répétition P inférieur à 30µm de manière encore plus avantageuse pour un pas de répétition P inférieur ou égale à 15µm.

L'utilisation d'un contact 5 ou de plusieurs contacts 5 électriquement conducteurs dans la matrice de photodétecteurs 1 permet de rendre le dispositif plus robuste vis-à-vis des risques de dépolarisation, par exemple quand le dispositif est soumis à un flux lumineux important.

Comme un photodétecteur 1 est remplacé par un contact 5 électriquement conducteur, il existe une zone de détection ne délivrant pas d'information sur la scène observée. Cette zone dépourvue d'information correspond à un pixel isolé. Grâce à des moyens de traitement, il est possible de compenser cette absence d'information en utilisant les informations données par ses voisins immédiats. Ce type de correction n'est pas possible ou facilement réalisable quand une sous-ligne de polarisation est utilisée et sacrifie une colonne ou une rangée entière de photodétecteurs 1.

Ainsi, dans un exemple, le dispositif comporte des moyens de génération d'un signal d'illumination à partir des photodétecteurs 1 adjacents au contact 5. Selon les exemples, entre quatre et huit photodétecteurs adjacents peuvent être utilisés pour générer un signal provenant artificiellement du contact 5. De cette manière, le dispositif transmet un signal (par exemple une image) représentatif de la scène observée en éliminant les zones d'ombre créées par le ou les contacts 5.

Dans la matrice de détection, le trou peut être assimilé à un photodétecteur défectueux dont on connaît à l'avance la position ce qui facilite la gestion des corrections à apporter pour avoir une information associée à chaque coordonnée de la matrice que cette zone soit occupée par un photodétecteur ou par un plot.

Les photodétecteurs 1 sont connectés à une première ligne en matériau métallique qui récupère l'information fournie par la matrice. La première ligne en matériau métallique relie le photodétecteur 1 au circuit de lecture 4. Le circuit de lecture 4 stocke l'information délivrée par le photodétecteur et il peut également intervenir dans la polarisation du photodétecteur 1. Chaque photodétecteur fournit un signal électrique (une tension ou un courant) qui est représentatif de la scène observée. Ce signal est acheminé par une ligne électrique jusqu'à des moyens de traitement de l'information via le circuit de lecture 4. Différents types de circuit de lecture sont possibles, par exemple des circuits à injection directe (DI), à injection directe contre-réactionnée (BDI) ou à amplificateur transimpédance capacitif (CTIA).

Le contact 5 électriquement conducteur est également connecté à une seconde ligne métallique et cette seconde ligne métallique est reliée au générateur 3 de tension de polarisation. La seconde ligne métallique est identique à la première ligne métallique. Les deux lignes métalliques sont formées dans le même matériau avec éventuellement les mêmes dimensions.

Dans cet exemple, la tension de polarisation V_{SUB} est appliquée au substrat à l'intérieur de la matrice de photodétecteurs 1 en utilisant les niveaux d'interconnexion métallique, c'est-à-dire sans avoir à apporter de nouvelles lignes de polarisation entre les photodétecteurs 1. Dans cette architecture, les conditions de polarisation appliquées sur la ligne métallique reliée au contact 5 ont un impact réduit sur les photodétecteurs.

L'utilisation d'un contact 5 électriquement conducteur relié au générateur 3 de tension de polarisation est particulièrement intéressant lorsque le substrat 6 présente une résistivité importante comparée aux conditions d'illumination acceptées par les photodétecteurs. A titre d'exemple, il est avantageux d'utiliser un ou plusieurs contacts électriquement conducteurs quand le substrat est dopé de type P car la conduction des porteurs de charge est moins bonne que pour les substrats dopés de type N. Cette architecture permet de former dans la matrice ou à côté de la matrice des photodiodes à avalanches ce qui n'est pas possible en inversant les types de dopage. Ces exemples sont particulièrement intéressants dans le cas où le substrat est un matériau à base de CdHgTe dont les caractéristiques électriques peuvent être insuffisantes pour intégrer des matrices de taille importante.

L'utilisation d'un contact 5 électriquement conducteur relié au générateur 3 de tension de polarisation est particulièrement intéressant lorsque la taille de la matrice de photodétecteurs est importante. De cette manière, le générateur 3 est en mesure d'appliquer le potentiel V_{SUB} au moyen de la ligne de polarisation 2 entourant la matrice et au moyen des contacts 5 disposés à l'intérieur de la matrice.

L'utilisation d'un contact 5 électriquement conducteur relié au générateur de tension de polarisation est particulièrement intéressant lorsque les photodétecteurs 1 sont associés aux domaines des grandes longueurs d'onde du spectre infra-rouge (8-15 µm) ce qui se traduit par la gestion d'une quantité importante de porteurs de charge dans le substrat.

En comparaison d'un anneau de polarisation classique qui découperait la matrice en une pluralité de sous-matrices, le contact électriquement conducteur évite de perdre une colonne et ou une ligne entière de photodétecteurs. Dans ce cas, la matrice obtenue est plus compacte c'est-à-dire qu'elle comporte un plus grand nombre de photodétecteurs par unité de surface.

La matrice de photodétecteurs 1 peut comporter plusieurs lignes de photodétecteurs et/ou plusieurs colonnes de photodétecteurs. Les contacts 5 électriquement conducteurs peuvent être formés sur une pluralité de lignes ou de colonnes différentes. Ainsi, une même ligne ou une même colonne de photodétecteur peut comporter plusieurs contacts 5 électriquement conducteurs. Dans un autre exemple, une même ligne ou une même colonne ne comporte pas plus d'un contact 5 afin de réduire l'impact du contact sur les informations fournies par la ligne et/ou la colonne et donc pour réduire l'impact sur le traitement de l'information.

Dans un exemple, la matrice de photodétecteurs 1 peut comporter des organisations différentes de photodétecteurs 1, par exemple il existe un décalage des photodétecteurs présents sur deux lignes ou deux colonnes successives afin de gagner en compacité. Les première et seconde directions d'organisation ne sont pas obligatoirement perpendiculaires. Cette architecture est particulièrement intéressante dans le cas d'une matrice bispectrale où deux types de photodétecteurs sont intégrés. Chaque type de photodétecteur réagit avec une longueur d'onde particulière. Pour ce type de dispositif, le substrat comporte plusieurs couches qui réagissent à des longueurs d'ondes différentes, ce qui rend difficilement utilisable la couche très dopée divulguée dans le document WO9815016A1. Les deux types de photodiode peuvent avoir des tailles différentes et/ou des influences différentes sur les propriétés électriques du substrat.

Dans le cas où les photodétecteurs sont des diodes de type PN ou NP, il y a deux zones avec des types opposés de conductivité qui ont une interface commune.

De manière avantageuse, le substrat 6 est du premier type de conductivité et des zones 7 d'un second type de conductivité sont formées à l'intérieur du substrat. Afin d'avoir une pluralité de diodes indépendantes, les zones 7 en second type de conductivité sont espacées les unes des autres.

Cependant, chaque diode présente une surface de collection des porteurs générés qui est supérieure à la surface occupée par la zone 7 du seconde type de conductivité. En d'autres termes, les porteurs générés hors de la diode peuvent être attirés et collectés par la diode. En d'autres termes, en vue de dessus, la surface de collection en porteurs déborde de la surface en second type de conductivité.

Dans un exemple, afin d'avoir une collection maximale de l'énergie lumineuse émise par la scène observée, il y a un chevauchement des zones de collection entre deux photodétecteurs 1 adjacents. Dans cette zone de chevauchement commune à deux photodétecteurs les porteurs de charge générés ont la possibilité d'être captés par l'un ou l'autre des photodétecteurs 1.

De manière avantageuse, les photodétecteurs 1 ont des architectures identiques et des conditions de polarisations identiques afin de faciliter le traitement de l'information émis par chaque photodétecteur 1 en comparaison des autres photodétecteurs 1 de la matrice. Dans ce cas de figure, les photodétecteurs 1 sont considérés comme identiques tant dans leur architecture que dans leur fonctionnement. Les photodétecteurs 1 ont la même surface de collection effective.

Dans le cas où le contact 5 comporte un plot 8 déposé sur une zone du premier type de conductivité et dépourvue d'une zone du second type de conductivité, il n'y a pas formation d'une diode, ni d'une zone de collection. Les photodétecteurs 1 adjacents à un contact 5 n'ont pas de zone de chevauchement avec le contact 5 et ils possèdent alors une surface de collection effective qui est supérieure aux autres photodétecteurs. Il existe un décalage dans le fonctionnement de ces photodétecteurs 1 lié à la zone de collection des porteurs de charge qui est supérieure à celles des autres photodétecteurs de la matrice.

Cette singularité de fonctionnement rend plus difficile le traitement de l'information en créant artificiellement des zones plus lumineuses que dans la réalité. Cet effet est d'autant plus marqué que la zone de chevauchement est importante dans la surface de collection des porteurs de charge.

Afin de rendre les photodétecteurs plus homogènes avec le reste de la population de la matrice, le contact 5 électriquement conducteur comporte avantageusement une zone 9 dopée du second type de conductivité de forme annulaire avec, en son centre, le substrat et/ou une zone 10 dopée du premier type de conductivité qui est en continuité électrique avec le substrat. De cette manière, le contact 5 électriquement conducteur comporte une zone centrale du premier type de conductivité et une zone périphérique du second type de conductivité. La zone 9 du second type de conductivité n'entoure pas complètement la zone du premier type de conductivité afin que la tension de polarisation V_{SUB} puisse être appliquée directement au substrat et non par l'intermédiaire d'une diode.

Cette zone 9 dopée du second type de conductivité vient simuler le fonctionnement d'une photodiode avec une surface de collection et créer une zone de chevauchement entre le contact 5 et chacun des photodétecteurs 1 adjacents. Cette zone de chevauchement réduit la surface de collection effective des photodétecteurs 1.

Le plot 8 est en contact électrique avec la zone 10 du premier type de conductivité et avec la zone 9 du second type de conductivité. La zone 10 peut être une partie du substrat ou une partie de la zone 9 qui a été dopée d'un type opposé par la suite afin de changer de conductivité. La distance séparant le bord extérieur de la zone 9 dopée du second type de conductivité de forme annulaire et la zone 7 dopée du second type de conductivité du photodétecteur 1 est identique à la distance qui sépare deux zones 7 dopées du second type de conductivité de deux photodétecteurs adjacents selon le premier axe d'organisation. La zone centrale et la zone périphérique du contact 5 ont des types de conductivité opposés et ces deux zones sont court-circuitées au moyen d'un matériau électriquement conducteur, par exemple un métal, de manière préférentielle par le plot 8 relié au générateur 3.

Cette architecture permet d'éviter la formation d'une diode entre la zone centrale et la zone périphérique du contact 5 ce qui est préjudiciable au bon fonctionnement du contact 5. Cela permet également d'utiliser la zone 9 périphérique pour réduire la surface de collection des photodétecteurs adjacents tout en réalisant la polarisation du substrat à la tension de polarisation V_{SUB} au moyen de la partie centrale du plot 5.

Dans un mode de réalisation particulier, la partie centrale du contact 5, c'est-à-dire la zone 10, dans le substrat présente une concentration en dopant supérieure à celle du reste du substrat 6.

Cette architecture particulière peut être réalisée simplement en formant la matrice de diodes PN ou NP dans le substrat. Les zones 7 des photodiodes et la zone 9 sont formées durant la même étape technologique, bien qu'il soit également envisageable de les former séparément. Ensuite, une zone 10 dopée du premier type de conductivité est formée dans la zone 9 du second type de conductivité de manière à réaliser une connexion directe entre le substrat 9 en premier type de conductivité et le plot 8 du contact 5. Il est également possible de changer l'ordre de formation des zones, par exemple en former la zone 10 en premier puis en formant les zones 7 et 9.

Ensuite, les plots 8 sont formés de manière conventionnelle comme le reste du procédé de mise en oeuvre du dispositif. Les plots sont par exemple des billes métalliques qui servent à l'interconnexion avec un second substrat qui comporte le module de lecture. Seul le routage des lignes métalliques est légèrement modifié afin de connecter le contact 5 au générateur 3 de tension de polarisation. Les plots sont disposés préférentiellement avec un pas de répétition constant, le pas de répétition des photodétecteurs.

Cette étape supplémentaire permet de manière simple et économique de transformer un photodétecteur de type diode PN ou NP en un contact de polarisation intégré directement à l'intérieur de la matrice.

De manière générale, le contact 5 comporte une zone 10 du premier type de conductivité et une zone 9 du second type de conductivité. Ces deux zones sont adjacentes et court-circuitées afin d'être polarisées au même potentiel, ici le potentiel de polarisation V_{SUB}. La première zone 10 du premier type de conductivité est en continuité de dopage avec le reste du substrat 6. De cette manière, la première zone 10 ne peut pas être formée et complètement délimitée dans un caisson du second de conductivité. Le type de conductivité est constant depuis la première zone 10 jusqu'au substrat. La seconde zone 9 peut entourée partiellement ou complètement la première zone 10 d'un point de vue latérale afin d'avoir un effet, sur une ou plusieurs surfaces de collection des zones adjacentes. Plusieurs zones 9, ici des zones 9a et 9b, distinctes les unes des autres peuvent être formées en face d'un ou plusieurs photodétecteurs pour modifier la zone de chevauchement.

Le détecteur comporte des moyens d'application de la tension de polarisation directement sur une zone du premier type de conductivité qui est en continuité de dopage avec le substrat et sur une zone du second type de conductivité. Ceci permet de former une diode dont l'influence latérale va réduire la surface de collection d'au moins un photodétecteur adjacent.

## Revendications

1. Dispositif de détection comportant :
- un substrat (6) semi-conducteur d'un premier type de conductivité,
- une matrice de photodiodes (1) organisées selon un premier axe d'organisation (X) avec un pas de répétition (P), chaque photodiode comportant une première électrode formée par une zone d'un second type de conductivité (7) opposé au premier type de conductivité et une seconde électrode formée par le substrat (6),
- un anneau (2) périphérique de polarisation formé dans le substrat autour de la matrice de photodiodes (1), l'anneau (2) de polarisation étant connecté à un générateur (3) de tension de polarisation pour appliquer une tension de polarisation (V_{SUB}) au substrat (6),
- un contact (5) disposé entre deux photodiodes (1) dans l'alignement du premier axe d'organisation (X), le contact (5) étant séparé des deux photodiodes (1) selon le premier axe d'organisation (X) par le pas de répétition (P) de manière à ce que le contact (5) remplace une photodiode (1), le contact (5) compartant :
- un plot électriquement conducteur (8) disposé sur le substrat (6) et connecté au générateur (3) de tension de polarisation pour appliquer la tension de polarisation (V_{SUB})au substrat (6),
- une première zone (6, 10) du premier type de conductivité configurée pour réaliser le passage de charges électriques entre le plot électriquement conducteur (8) et le substrat (6), dispositif **caractérisé en ce qu'**une seconde zone (9) du second type de conductivité est agencée pour être en contact avec le plot électriquement conducteur (8), le plot électriquement conducteur (8) court-circuitant les première (10) et seconde (9) zones.

2. Dispositif selon la revendication 1, **caractérisé en ce que** la seconde zone (9) forme un anneau autour de la première zone (10).

3. Dispositif selon l'une des revendications 1 et 2, **caractérisé en ce qu'**il comporte une pluralité de contacts (5) électriquement conducteurs connectés au substrat (6) sur le premier axe d'organisation (X), les contacts (5) étant agencés entre les photodiodes (1) à intervalle régulier, selon un premier pas de répétition qui est un multiple du pas de répétition (P) des photodiodes (1).

4. Dispositif selon la revendication 3, **caractérisé en ce que** la matrice de photodiodes (1) est organisée suivant un deuxième axe d'organisation (Y), les contacts (5) étant agencés selon le deuxième axe d'organisation (Y) avec un deuxième pas de répétition.

5. Dispositif selon l'une quelconque des revendications 1 à 4, **caractérisé en ce qu'**une première ligne métallique relie une photodiode (1) à un circuit de lecture (4) et une deuxième ligne métallique relie le contact (5) au générateur (3) de tension de polarisation.

6. Procédé de fabrication d'un dispositif de détection comportant les étapes suivantes : prévoir un substrat (6) semi-conducteur d'un premier type de conductivité,
- former une matrice de photodiodes (1) organisées selon un premier axe d'organisation (X) avec un pas de répétition (P), chaque photodiode comportant une première électrode formée par une zone d'un second type de conductivité (7) opposé au premier type de conductivité et une seconde électrode formée par le substrat (6),
- former un contact (5) disposé entre deux photodiodes (1) dans l'alignement du premier axe d'organisation (X), le contact (5) étant séparé des deux photodiodes (1) selon le premier axe d'organisation (X) par le pas de répétition (P) de manière à ce que le contact (5) remplace une photodiode (1), le contact (5) comportant :
- un plot électriquement conducteur (8) disposé sur le substrat (6) et connecté au générateur (3) de tension de polarisation pour appliquer la tension de polarisation (V_{SUB}) au substrat (6), le générateur (3) de tension de polarisation étant connecté à un anneau (2) périphérique formé dans le substrat (6) et entourant la matrice de photodiodes (1),
- une première zone (6, 10) du premier type de conductivité configurée pour réaliser le passage de charges électriques entre le plot électriquement 15 conducteur (8) et le substrat (6), **caractérisé en ce qu'**une seconde zone (9) du second type de conductivité est agencée pour être en contact avec le plot électriquement conducteur (8), le plot électriquement conducteur (8) court-circuitant les première (10) et seconde (9) zones.

## Patentansprüche

1. Erfassungsvorrichtung mit:
- einem Halbleitersubstrat (6) von einem ersten Leitfähigkeitstyp,
- einer Matrize von Photodioden (1), die gemäß einer ersten Organisationsachse (X) mit einem Wiederholungsschritt (P) eingerichtet ist, wobei jede Photodiode eine erste Elektrode, die durch einen Bereich von einem zweiten Leitfähigkeitstyp (7) entgegengesetzt zu dem ersten Leitfähigkeitstyp gebildet ist, und eine zweite Elektrode aufweist, die durch das Substrat (6) gebildet ist,
- einem umlaufenden Polarisationsring (2), der in dem Substrat um die Matrize von Photodioden (1) herum ausgebildet ist, wobei der Polarisationsring (2) mit einem Polarisationsspannungsgenerator (3) verbunden ist, um eine Polarisationsspannung (V_{SUB}) auf das Substrat (6) aufzubringen,
- einem zwischen zwei Photodioden (1) in der Ausrichtung der ersten Organisationsachse (X) angeordneten Kontakt (5), wobei der Kontakt (5) von den beiden Fotodioden (1) gemäß der ersten Organisationsachse (X) durch den Wiederholungsschritt (P) derart getrennt ist, dass der Kontakt (5) eine Fotodiode (1) ersetzt, wobei der Kontakt (5) Folgendes umfasst:
- ein elektrisch leitendes Stück (8), das auf dem Substrat (6) angeordnet ist und mit dem Polarisationsspannungsgenerator (3) zum Aufbringen der Polarisationsspannung (V_{SUB}) auf das Substrat (6) verbunden ist,
- einen ersten Bereich (6, 10) von dem ersten Leitfähigkeitstyp, der zur Umsetzung des Durchgangs von elektrischen Ladungen zwischen dem elektrisch leitenden Stück (8) und dem Substrat (6) ausgeführt ist,
wobei die Vorrichtung **dadurch gekennzeichnet ist, dass**
ein zweiter Bereich (9) von dem zweiten Leitfähigkeitstyp derart angeordnet ist, dass er in Kontakt mit dem elektrisch leitenden Stück (8) steht, wobei das elektrisch leitende Stück (8) den ersten (10) und zweiten (9) Bereich kurzschließt.

2. Vorrichtung nach Anspruch 1, **dadurch gekennzeichnet, dass** der zweite Bereich (9) einen Ring um den ersten Bereich (10) herum bildet.

3. Vorrichtung nach einem der Ansprüche 1 und 2, **dadurch gekennzeichnet, dass** sie eine Vielzahl von elektrisch leitenden Kontakten (5) umfasst, welche mit dem Substrat (6) auf der ersten Organisationsachse (X) verbunden sind, wobei die Kontakte (5) zwischen den Photodioden (1) in regelmäßigem Abstand gemäß einem ersten Wiederholungsschritt angeordnet sind, der ein Vielfaches des Wiederholungsschrittes (P) der Photodioden (1) darstellt.

4. Vorrichtung nach Anspruch 3, **dadurch gekennzeichnet, dass** die Matrize von Photodioden (1) gemäß einer zweiten Organisationsachse (Y) eingerichtet ist, wobei die Kontakte (5) gemäß der zweiten Organisationsachse (Y) mit einem zweiten Wiederholungsschritt angeordnet sind.

5. Vorrichtung nach einem der Ansprüche 1 bis 4, **dadurch gekennzeichnet, dass** eine erste Metallleitung eine Photodiode (1) mit einem Ablesekreis (4) verbindet und eine zweite Metallleitung den Kontakt (5) mit dem Polarisationsspannungsgenerator (3) verbindet.

6. Herstellungsverfahren für eine Erfassungsvorrichtung mit den folgenden Schritten:
- Vorsehen eines Halbleitersubstrates (6) von einem ersten Leitfähigkeitstyp,
- Bilden einer Matrize von Photodioden (1), die gemäß einer ersten Organisationsachse (X) mit einem Wiederholungsschritt (P) eingerichtet ist, wobei jede Photodiode eine erste Elektrode, welche durch einen Bereich von einem zweiten Leitfähigkeitstyp (7) entgegengesetzt zu dem ersten Leitfähigkeitstyp gebildet ist, und eine zweite Elektrode aufweist, die durch das Substrat (6) gebildet ist,
- Bilden eines Kontaktes (5), der zwischen zwei Photodioden (1) in der Ausrichtung der ersten Organisationsachse (X) angeordnet ist, wobei der Kontakt (5) von zwei Photodioden (1) gemäß der ersten Organisationsachse (X) durch den Wiederholungsschritt (P) derart getrennt ist, dass der Kontakt (5) eine Photodiode (1) ersetzt, wobei der Kontakt (5) Folgendes umfasst:
- ein elektrisch leitendes Stück (8), das auf dem Substrat (6) angeordnet ist und mit dem Polarisationsspannungsgenerator (3) verbunden ist, um die Polarisationsspannung (V_{SUB}) auf das Substrat (6) aufzubringen, wobei der Polarisationsspannungsgenerator (3) mit einem umlaufenden Ring (2) verbunden ist, der in dem Substrat (6) ausgebildet ist und die Matrize von Photodioden (1) umgibt,
- einen ersten Bereich (6, 10) von dem ersten Leitfähigkeitstyp, der zur Umsetzung des Durchgangs elektrischer Ladungen zwischen dem elektrisch leitenden Stück (8) und dem Substrat (6) ausgeführt ist,
**dadurch gekennzeichnet, dass**
ein zweiter Bereich (9) von dem zweiten Leitfähigkeitstyp so angeordnet ist, dass er mit dem elektrisch leitenden Stück (8) in Kontakt steht, wobei das elektrisch leitende Stück (8) den ersten (10) und zweiten (9) Bereich kurzschließt.

## Claims

1. A detection device comprising:
- a semiconductor substrate (6) of a first conductivity type,
- a matrix of photodiodes (1) organized along a first organization axis (X) with a repetition pitch (P), each photodiodes (1) comprising a first electrode formed by an area of a second conductivity type (7) opposite to the first conductivity type and a second electrode formed by the substrate (6),
- a peripheral biasing ring (2) formed in the substrate around the photodiode matrix (1), the biasing ring (2) being connected to a bias voltage generator (3) to apply a bias voltage (V_{SUB}) to the substrate (6),
- a contact (5) arranged between two photodiodes (1) in the alignment of the first organization axis (X), the contact (5) being separated from the two photodiodes (1) along the first organization axis (X) by the repetition pitch so that the contact (5) replaces a photodiode (1), the contact (5) comprising:
- an electrically conducting bump (8) arranged on the substrate (6) and connected to the bias voltage generator (3) to apply the bias voltage (V_{SUB}) to the substrate (6),
- a first area (6, 10) of first conductivity type configured to perform passage of electric charges between the electrically conducting bump (8) and the substrate (6),
a device **characterized in that**
- a second area (9) of second conductivity type is arranged to be in contact with the electrically conducting bump (8), the electrically conducting bump (8) short-circuits the first area (10) and second area (9).

2. The device according to claim 1, **characterized in that** the second area (9) forms a ring around the first area (10).

3. The device according to one of claims 1 and 2, **characterized in that** it comprises a plurality of electrically conducting contacts (5) connected to the substrate (6) along the first organization axis (X), the contacts (5) being arranged between the photodiodes (1) at regular intervals with a first repetition pitch which is a multiple of the repetition pitch (P) of the photodiodes (1).

4. The device according to claim 3, **characterized in that** the photodiodes matrix (1) is organized along a second organization axis (Y), the contacts (5) being arranged along the second organization axis (Y) with a second repetition pitch.

5. The device according to any one of claims 1 to 4, **characterized in that** a first metal line couples a photodiode (1) to a readout circuit (4) and a second metal line connects the contact (5) to the bias voltage generator (3).

6. A fabrication method of a detection device comprising the following steps:
- providing a semiconductor substrate (6) of a first conductivity type,
- forming a matrix of photodiodes (1) organized along a first organization axis (X) with a repetition pitch (P), each photodiodes (1) comprising a first electrode formed by an area of a second conductivity type (7) opposite to the first conductivity type and a second electrode formed by the substrate (6),
- forming a contact (5) arranged between two photodiodes (1) in the alignment of the first organization axis (X), the contact (5) being separated from the two photodiodes (1) along the first organization axis (X) by the repetition pitch so that the contact (5) replaces a photodiode (1), the contact (5) comprising:
- an electrically conducting bump (8) arranged on the substrate (6) and connected to the bias voltage generator (3) to apply the bias voltage (V_{SUB}) to the substrate (6), the bias voltage generator (3) being connected to a peripheral ring (2) formed in the substrate (6) and arranged to surrender the photodiode matrix (1),
- a first area (6, 10) of first conductivity type configured to perform passage of electric charges between the electrically conducting bump (8) and the substrate (6),
**characterized in that** a second area (9) of second conductivity type is arranged to be in contact with the electrically conducting bump (8), the electrically conducting bump (8) short-circuiting the first area (10) and second area (9).
